# EUROPEAN PATENT APPLICATION

(11) **EP 4 712 347 A1**
(43) Date of publication of application: **18.03.2026**
(21) Application number: 24200414.1
(22) Date of filing: 13.09.2024
(51) Int. Cl.: H03K 3/011, H03K 3/013, H03K 3/03, H03L 7/099

(54) **INVERTER AND RING OSCLLATOR BASED ON INVERTER**

(71) Applicant: NXP B.V., 5656 AG Eindhoven (NL)
(72) Inventor: Sedighzadeh Yazdi, Siavash, 5656 AG Eindhoven (NL); Vakili-Amini, Babak, 5656 AG Eindhoven (NL); Enam, Syed Khursheed, 5656 AG Eindhoven (NL)
(74) Representative: Krott, Michel

(57) **Abstract**

An inverter and a ring oscillator (100) comprising a plurality of the inverters arranged in a ring is disclosed. Each inverter (200) comprises an inverter input (210) and an inverter output (220), wherein the inverter output (220) of each inverter (200) in the ring is coupled to the inverter input (210) of the respective next inverter (200) in the ring. At least one (200) of the plurality of inverters comprises: a first NMOS transistor (250), comprising a first gate terminal (252) coupled to the respective inverter input (210), a first drain terminal (254) coupled to the respective inverter output (220), and a first source terminal (256); and a second NMOS transistor (260), comprising a second gate terminal (262), a second drain terminal (264) and a second source terminal (266), wherein said second source terminal (266) is coupled to said first drain terminal (254).

## Description

### FIELD

The present disclosure relates to an inverter cell and a ring oscillator based on the inverter cell. More particularly, but not exclusively, the present disclosure relates to an inverter cell, ring oscillator and phase-locked loop comprising the ring oscillator, having a low sensitivity to fluctuations in the supply voltage.

### BACKGROUND

A problem associated with ring oscillators is their high supply sensitivity. This can create a path for noise or ripple on the supply voltage to modulate the output frequency of the ring oscillator. A common way to address this problem is by adding high Power Supply Rejection Ratio (PSRR) Low Drop Out regulators (LDOs) and/or active current sources on top of the ring oscillator to reject any noise/ripple from reaching the ring oscillator supply voltage. This additional circuitry increases the minimum supply voltage requirements to accommodate the high PSRR circuitry, limiting the minimum achievable supply voltage for the ring oscillator. In systems comprising a ring oscillator (e.g. a radio transceiver), this additional high PSRR circuitry may limit the minimum achievable supply voltage for the whole system, increasing the overall power consumption of the system.

Another problem associated with ring oscillators is their high temperature-sensitivity. When used in a phase-locked loop (PLL), this means that, once the PLL loop is locked, large temperature drifts may cause the PLL to go out of lock and require relocking. If the PLL is used for timekeeping in a system, the relocking results in increased system complexity or loss of time information.

### SUMMARY

Aspects of the disclosure are set out in the accompanying claims. Combinations of features from the dependent claims may be combined with features of the independent claims as appropriate and not merely as explicitly set out in the claims.

According to a first aspect of the disclosure, there is provided an inverter, comprising: a first NMOS transistor, comprising a first gate terminal, a first drain terminal and a first source terminal; an inverter input coupled to said first gate terminal; an inverter output coupled to said first drain terminal; and a second NMOS transistor, comprising a second gate terminal, a second drain terminal and a second source terminal, wherein said second source terminal is coupled to said first drain terminal.

By providing an inverter based on a first nmos transistor (effectively, an nmos driver) and a second nmos transistor (effectively, an nmos load), a delay between the inverter input and inverter output signals is less sensitive to the supply voltage of the inverter. In turn, this lower supply sensitivity may enable a reduction of the supply voltage and a lower power consumption. Similarly, a plurality of such inverters may form the basis of a ring oscillator having an oscillation frequency which is less sensitive to supply voltage fluctuations, leading to a reduction in the supply voltage of the ring oscillator. Reducing the supply voltage to the inverter or ring oscillator may ultimately lead to lower overall power consumption for a device or system comprising the inverter or ring oscillator.

According to a second aspect of the disclosure, there is provided a ring oscillator, comprising: a plurality of inverters arranged in a ring, wherein each inverter comprises an inverter input and an inverter output, and wherein the inverter output of each inverter in the ring is coupled to the inverter input of the respective next inverter in the ring; and wherein at least one inverter of said plurality of inverters further comprises: a first NMOS transistor, comprising a first gate terminal coupled to said respective inverter input, a first drain terminal coupled to said respective inverter output, and a first source terminal; and a second NMOS transistor, comprising a second gate terminal, a second drain terminal and a second source terminal, wherein said second source terminal is coupled to said first drain terminal.

Since the ring oscillator is less sensitive to supply voltage, it may provide a higher quality of output and/or a lower power consumption than conventional ring oscillators.

In some embodiments, the inverter may further comprise: a bias voltage input coupled to said second gate terminal.

Controlling a bias voltage at the bias voltage input may be helpful in controlling the delay of the inverter, or the oscillation frequency of the ring oscillator.

In some embodiments, the inverter may further comprise: a resistance coupled between said bias voltage input and said second gate terminal.

By coupling a resistance to the gate of the second NMOS transistor, the gain of the inverter is increased at oscillation frequencies, which may help to ensure oscillation.

In some embodiments, the resistance is a variable resistance.

By varying the resistance, the resistance may be used for calibration of the delay of the inverter or the oscillation frequency of the ring oscillator, for example during a one-time process calibration, since the value of the resistance controls the charging current at the inverter output at oscillation frequencies.

In some embodiments, the inverter or the ring oscillator further comprises: circuitry configured to generate a bias voltage at said bias voltage input, said bias voltage varying as a function of temperature.

By controlling the bias voltage as a function of temperature, it is possible to counteract temperature-dependent variations of the inverter delay and thereby to counteract temperature-dependent variations of the oscillation frequency of a ring oscillator based on the inverter.

In some embodiments, the inverter may further comprise: at least one capacitance coupled between said inverter output and a reference voltage.

The at least one capacitance may be used to set or calibrate the delay of the inverter, or the oscillation frequency or phase of the ring oscillator.

The at least one capacitance may be coupled to one of the inverter output and the reference voltage by a switch, e.g., a transistor.

The at least one capacitance may comprise a plurality of parallel-coupled switched capacitances. This may allow the overall value of the at least one capacitance, in the form of a plurality of parallel-coupled switched capacitances, to be programmed or controlled by a digital signal via the switches. The at least one capacitance may comprise a switched-capacitor DAC.

In some embodiments, the inverter may further comprise: at least one variable capacitance coupled between said inverter output and a control voltage.

In some embodiments, the at least one variable capacitance comprises a MOS varactor. The control voltage may be coupled to the gate of the MOS varactor for controlling the capacitance of the variable capacitance.

The at least one variable capacitance may be used for tuning the delay of the inverter, or the oscillation frequency or phase of the ring oscillator. For example, the control voltage may provide phase and/or frequency control of the ring oscillator when used as a voltage controlled oscillator in a phase-locked loop or frequency-locked loop.

In some embodiments, the second drain terminal is coupled to a supply voltage.

In some embodiments, the first source terminal is coupled to a reference voltage.

In some embodiments, the ring oscillator further comprises: circuitry comprising an output coupled to the bias voltage input of said at least one inverter; said circuitry being configured to generate, at its output, a bias voltage.

This may provide an additional pathway for controlling the delay of the inverter and thus the frequency or phase of the ring oscillator.

In some embodiments, said bias voltage is dependent on temperature.

By controlling the bias voltage as a function of temperature, it is possible to counteract temperature-dependent variations of the inverter delay and thereby to counteract temperature-dependent variations of the oscillation frequency of a ring oscillator based on the inverter. There are at least two opposing mechanisms controlling the inverter delay: as temperature increases, threshold voltages drop but mobility drops too. Whether the bias voltage needs to be increasing or decreasing with temperature depends on the semiconductor process.

In some embodiments, said bias voltage has a first temperature dependency for temperatures above a predetermined temperature offset, and a second, different, temperature dependency for temperatures below the predetermined temperature offset.

By controlling the temperature dependency of the bias voltage above the predetermined temperature offset (e.g., an operating temperature, such as room temperature) and the temperature dependency of the bias voltage below the predetermined temperature offset independently of each other, it is possible to improve the stability of the inverter and ring oscillator with respect to temperature variations. This allows a better adaptation of the bias voltage to the non-linear dependence of the inverter drive current with temperature.

In some embodiments, said circuitry is configured to receive said control voltage and to further control said bias voltage based on said control voltage.

In some embodiments, said circuitry is configured to generate said bias voltage based on a temperature-dependent current.

Said temperature-dependent current may be a current proportional to absolute temperature.

In some embodiments, the circuitry comprises: a first portion configured to generate a bias current based on said temperature-dependent current, wherein said bias current varies linearly with temperature with a first slope at temperatures below the predetermined temperature offset, and wherein said bias current varies linearly with temperature with a second slope at temperatures above the predetermined temperature offset; and a second portion configured to generate said bias voltage based on said bias current.

In some embodiments, said first portion of the circuitry comprises a current-subtraction circuit configured to subtract said current proportional to absolute temperature from a constant current.

In some embodiments, said circuitry is configured to receive a control voltage and to control a gain of said bias current dependent on said control voltage.

This provides an additional pathway for controlling the delay of the inverter and thus the frequency or phase of the ring oscillator. In particular, by using the control voltage to control the gain of the temperature-dependent bias current, this may correct for any frequency or phase drift caused by temperature effects not compensated by the temperature-dependent biassing alone. When used in a phase-locked loop, this additional tuning pathway may help to keep the PLL locked over a larger temperature range without the need for recalibration.

The control voltage may provide frequency control of the ring oscillator when used as a voltage controlled oscillator in a phase-locked loop.

In some embodiments, said circuitry comprises at least one RC filter for filtering said bias current.

This filter has the effect of slowing down the feedback loop of the additional tuning pathway, ensuring that only slow variations of the control voltage are used to control the delay of the inverter via the bias voltage input. Thus, when the ring oscillator is used in a PLL, the additional tuning pathway does not affect the noise performance or loop dynamics of a PLL. The filter may also help to remove any noise generated in the circuitry.

In some embodiments, said second portion comprises a replica delay cell comprising a replica of the first and second NMOS transistors.

Using a replica delay cell helps the bias voltage to track process variations of the temperature effects in the inverter.

In some embodiments, a gate terminal and a drain terminal of the replica first NMOS transistor are coupled to a source terminal of the replica second NMOS transistor; a gate terminal of the replica second NMOS transistor is coupled to a drain terminal of the second NMOS transistor; and an output of the second portion of the circuitry is coupled to the drain terminal of the second NMOS transistor.

In some embodiments, a ring oscillator output may be coupled to the invertor output of one of said plurality of inverters of the ring oscillator.

In some embodiments, said at least one inverter further comprises: at least one variable capacitance coupled between said inverter output and a control voltage; and the ring oscillator further comprises: circuitry comprising an output coupled to the bias voltage input of said at least one inverter; said circuitry being configured to generate, at its output, a bias voltage varying as a function of temperature; wherein said circuitry is configured to receive said control voltage and to control a gain of said bias voltage based on said control voltage.

Accordingly, two pathways are provided for controlling the frequency or phase of the ring oscillator via the control voltage. The circuitry may include a lowpass filter so that high-frequency variations of the control voltage are not fed back to the bias voltage input of the inverter.

According to another aspect of this disclosure, there is provided a phase-locked loop comprising said ring oscillator according to the second aspect of the present disclosure.

The phase locked loop may further comprise: a phase comparator for outputting a control signal dependent on a difference between a phase of a signal at an output of the ring oscillator and a phase of a reference signal.

The phase comparator may comprise a loop filter for filtering high frequency components from the control signal.

In some embodiments, the ring oscillator is coupled to the output of the phase comparator via a first pathway and a second pathway.

In some embodiments, said at least one inverter of said ring oscillator comprises a bias voltage input coupled to said second gate terminal; the ring oscillator comprises circuitry comprising an output coupled to the bias voltage input of said at least one inverter, wherein said circuitry is configured to generate, at its output, a bias voltage, and wherein said circuitry is configured to receive said control voltage and to control said bias voltage based on said control voltage; wherein said circuitry is configured to receive said control voltage via said second pathway.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### BRIEF DESCRIPTION OF THE DRAWINGS

Example embodiments of the present disclosure will be described, by way of example only, with reference to the accompanying drawings in which like reference signs relate to like elements and in which:
Figure 1 schematically illustrates a ring oscillator according to an example embodiment of the disclosure;
Figure 2 schematically illustrates a delay cell comprising an inverter according to an example embodiment of the present disclosure;
Figure 3 schematically illustrates (top) a current-subtraction circuit, comprised in circuitry for generating a bias voltage for biasing the inverter in the delay cell of Figure 2, and (bottom) plots of the input currents and the difference current output by the current-subtraction circuit as a function of temperature;
Figure 4 schematically illustrates (top) a bias current generating circuit, comprised in circuitry for generating a bias voltage for biasing the inverter in the delay cell of Figure 2, (middle) plots of the input currents and difference currents generated in the bias current generating circuit as a function of temperature, and (bottom) the bias current generated by the bias current generating circuit as a function of temperature;
Figure 5 schematically illustrates the bias voltage generating circuit for the ring oscillator of Figure 1, according to an example embodiment of the present disclosure; and
Figure 6 schematically illustrates a phase locked loop, comprising the ring oscillator of Figure 1, according to an example embodiment of the present disclosure.

### DETAILED DESCRIPTION

Ring oscillators are known for their small size and are used instead of LC Voltage-Controlled Oscillators (VCOs), when the phase noise requirements are not stringent, to save area. A simple ring oscillator comprises an odd number of inverter cells that are connected in cascade, with the output of the last inverter being connected to the input of the first inverter. As a signal propagates through each inverter it experiences a delay and therefore the oscillation frequency of the ring oscillator depends on the delay of each inverter and the total number of inverters in the ring. Since the delay of each inverter depends on the time taken to charge/discharge its output capacitor, the oscillation frequency of the ring oscillator may be controlled by controlling the capacitance of the output capacitor and/or by controlling the current available for charging and/or discharging the output capacitor.

Ring oscillators are commonly based on the CMOS inverter, which is known for its simplicity and rail-to-tail swing. Because the swing of the CMOS inverter is equal to its supply voltage, the supply voltage directly controls the current drive strength of the inverter devices and hence affects the oscillation frequency of the ring oscillator. Indeed, in many designs the supply voltage of a CMOS ring oscillator is used to control its frequency. However, this can also be a drawback of such ring oscillators. Any ripple on the supply voltage of a CMOS ring oscillator modulates the oscillation frequency and creates a spur at the output of the ring oscillator. As an example, if a CMOS ring oscillator is used as the clock source of an analog-to-digital converter (ADC), this spur can degrade the clock quality and can degrade the quality of the ADC output.

In a System-on-Chip (SoC), there usually exists a switching regulator (e.g., a DC-DC converter) to set the supply voltage of the radio with high efficiency. Due to the switching nature of these converters, there is always a ripple on the generated output voltage of the converter that can reach tens of millivolts (mV). If such a voltage is directly used as the supply of a CMOS ring oscillator, it can create strong spurs due to the supply sensitivity of the ring oscillator. To reduce the effect of this ripple, usually a low-dropout (LDO) voltage regulator and/or current source with high power supply rejection ratio (PSRR) is used to reject this ripple before reaching the ring oscillator. The supply rejection of an LDO or current source depends on the voltage drop-out on it. The higher the voltage dropout, the better the achievable PSRR. So, to achieve a sufficient rejection of the supply spur, the switching converter output voltage has to be set higher, such that there is enough drop-out voltage for the LDO or current source to provide sufficient rejection. This can increase overall power consumption for the system comprising the ring oscillator.

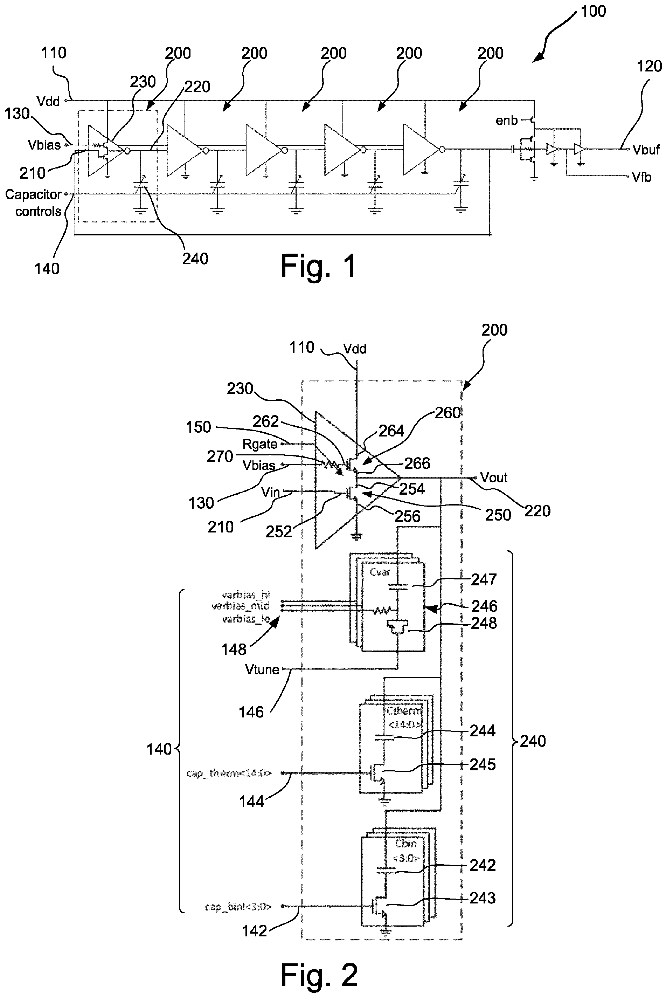

Figure 1 schematically illustrates a ring oscillator according to an example embodiment of the present disclosure, in the form of a five-stage ring oscillator 100 having an oscillation frequency of, for example, 2GHz. However, a ring oscillator according to the present disclosure could be designed with any odd number of delay cells (stages) 200 based on the frequency requirements.

The ring oscillator 100 comprises an odd number (five in this example) of delay cells 200, coupled in a ring arrangement. That is, an output 220 of each inverter cell 200 is coupled to an input 210 of the respective next inverter cell in the ring. The ring oscillator 100 is coupled to a supply voltage Vdd 110 and a reference voltage or ground. An output terminal Vbuf 120 of the ring oscillator 110 is coupled to an output 220 of one inverter cell 200 of the plurality of inverter cells via a buffer. The ring oscillator 100 comprises various control inputs including a bias voltage input Vbias 130, capacitor controls 140, and a further control input Rgate 150 (see Figure 2, not shown in Figure 1). These control inputs may be used for controlling or calibrating the delay between the inverter input 210 and inverter output 220, preferably for all the delay cells 200, and thus the oscillation frequency of the ring oscillator 100.

Each delay cell 200 comprises an inverter 230 according to the present disclosure, and respective capacitances 240 for tuning the inverter 230. For simplicity, the respective tuning capacitances 240 are represented as a single variable capacitance in Figure 1 having a single control input 140. However, each tuning capacitance 240 may comprise multiple capacitances, each optionally being separately controllable, as will be described with reference to Figure 2.

Figure 2 schematically illustrates a delay cell 200 according to an example embodiment of the present disclosure. The delay cell 200 comprises an inverter 230, and respective capacitances 240 for tuning the inverter 230.

The inverter 230 comprises a first NMOS transistor 250 (effectively, a common-source NMOS 'driver') and a second NMOS transistor 260 (effectively, a common-drain NMOS 'load'). The first NMOS transistor 250 comprises a first gate terminal 252, a first drain terminal 254 and a first source terminal 256. The second NMOS transistor 260 comprises a second gate terminal 262, a second drain terminal 264 and a second source terminal 266. The second source terminal 266 is coupled to the first drain terminal 254. The inverter input Vin 210 is coupled to the first gate terminal 252. The inverter output Vout 220 is coupled to the first drain terminal 254.

The second drain terminal 264 is coupled to the supply voltage Vdd 110, and the first source terminal 256 is coupled to a ground or reference voltage. A bias voltage input Vbias 130 is coupled to the second gate terminal 262 via a variable resistance 270. A further control voltage input Rgate 150 is provided for controlling the value of the variable resistance 270.

The capacitances 240 for tuning the inverter 230 are coupled in parallel to the inverter output Vout 220. These include a first capacitance, Cbin, 242, a second capacitance, Ctherm, 244, and a variable capacitance Cvar 246. The capacitor controls 140 include a first control input, cap_bini, 142 for controlling the value of the first capacitance Cbin 242, a second control input, cap_therm, 144 for controlling the effective value of the second capacitance, Ctherm, 244 and a third control input Vtune 146 for controlling the effective value of the variable capacitance Cvar 246.

Each of the first and second capacitances Cbin 242, Ctherm 244 is provided in the form of a programmable switched-capacitor DAC, comprising a plurality of parallel-coupled switched capacitances. Each switched capacitance comprised in the first and second capacitances 242, 244, comprises a fixed capacitance, having a first terminal coupled to the inverter output Vout 220, and a second terminal coupled to the ground or reference voltage via a respective transistor 243, 245. The first and second control inputs 144, 142 are coupled to the respective gates of the transistors for switching the respective first or second capacitance Cbin 242, Ctherm 244. The overall values of the first and second capacitances 242, 244, may thereby be programmed or controlled by digital control signals cap_bini and cap_therm received at the first and second control inputs 142, 144.

The variable capacitance Cvar 246 comprises a fixed capacitance 247 and a varactance 248, coupled in series between the inverter output Vout 220 and the third control input 146, configured to receive a tuning voltage Vtune 146. The varactance 248 is provided by a MOSFET transistor 248. The fixed capacitance 247 is coupled between the inverter output Vout 220 and a node, the node being coupled to both the source and drain of the MOSFET transistor 248. The tuning voltage Vtune 146 is coupled to the gate of the MOSFET transistor for controlling the capacitance of the varactance 248. The capacitance of the MOS varactor depends on the DC voltage across it, but is linear only in a narrow range of voltages. Accordingly, a biassing voltage varbias_hi/mid/lo 148 is applied to the source and drain of the MOSFET transistor 248. To increase the linear range of the variable capacitance 246, several different varactors 248, each coupled in series with a respective fixed capacitance 247, may be coupled in parallel and biassed at different voltages. When the ring oscillator 100 is used as a voltage controlled oscillator (VCO) in a phase-locked loop (PLL), with Vtune being the tuning voltage for the VCO, this feature may improve the linearity of the VCO gain Kvco with the tuning voltage Vtune 146. In the embodiment shown in Figure 2, three varactors 248 are coupled in parallel and biassed using different respective biassing voltages 148 (varbias_hi, varbias_mid and varbias_lo).

The skilled person will understand that the arrangement of capacitances, Cbin 242, Ctherm 244 and Cvar 246 shown in Figure 2 is only one example and that other combinations or arrangements of capacitances may alternatively or additionally be coupled to the inverter output for controlling the delay of the inverter 230 and thus the oscillation frequency of the ring oscillator 100.

Since the supply voltage Vdd 110 is connected to the drain of the second NMOS transistor 260 (i.e., the second drain terminal 264), the drive current of the delay cell 200 is not affected by the supply voltage provided that the first and second NMOS transistors 250, 260 operate in saturation region.

The second (common drain) NMOS transistor 260 has a low output resistance and hence the gain of the inverter 230 is low. To guarantee oscillation of the ring oscillator 100, a gate resistor (Rgate) 270 is added at the gate of the second NMOS transistor (i.e., the second gate terminal 262). At oscillation frequencies, the gate-source capacitance (Cgs) of the second (common drain) NMOS transistor 260 is shorted and the actual load seen by the first NMOS transistor 250 (the common-source NMOS 'driver') is the resistance Rgate 270. This increases the gain of the inverter 230 at oscillation frequency and guarantees oscillation.

Unlike a CMOS inverter, the inverter 230 needs to be biased. The biasing is done by a replica bias circuit, which produces a bias voltage Vbias at the bias voltage input 130, which is coupled to the gate 262 of the second (common drain) NMOS transistor 260 through the resistance Rgate 270. Since this bias voltage Vbias 130 is controlling the drive strength of the inverter 230, the oscillation frequency of the ring oscillator 100 is sensitive to variation in the bias voltage Vbias at this node 130. However, the bias voltage input 130 does not carry any DC current, and it can be heavily filtered by large RC filters to supress any ripple coupled through the supply. Also, the value of the variable resistance Rgate 270 controls the charging current at the inverter output Vout 220 and can also be used for coarse tuning of the oscillation frequency.

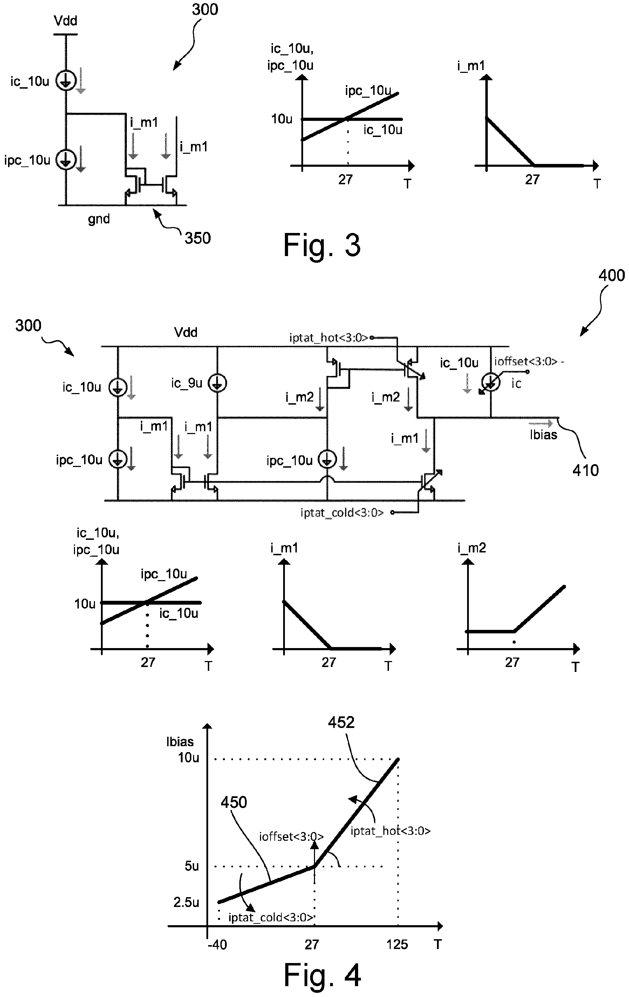

Calibration of the ring oscillator 100 (for example, for use as a voltage-controlled oscillator (VCO) in a phase-locked loop (PLL)) may be achieved as follows. The programmable variable resistance Rgate 270 may be used for one-time process calibration, by setting the control voltage input Rgate 150 appropriately. The programmable capacitor DACs 242, 244, may be used for adjusting the oscillator frequency close to the target frequency before closing the PLL loop. The variable capacitance Cvar 246 (including the MOS varactors 248) is used for continuous tracking and are controlled by the control voltage Vtune 146, which may correspond to the tuning voltage of the PLL loop. There is also the possibility of controlling the oscillation frequency through Vbias 130 and this may be used in a temperature tracking loop which will be described below with reference to Figures 3 to 5.

Another significant issue with ring oscillators is their sensitivity to temperature. Since the threshold voltage, mobility and other parameters of a MOS transistor depends on temperature, the drive current of an inverter can change with temperature. In a ring oscillator, this can result in frequency drift of the oscillation frequency. When used in a phase-locked loop (PLL), this means that, once the PLL loop is locked, large temperature drifts may cause the PLL to go out of lock and require relocking.

To improve the temperature stability of the inverter cell 200 and ring oscillator 100 disclosed above, the bias voltage Vbias 130 is caused to vary with temperature in order to counteract the effect of temperature on the inverter 230. For example, the bias voltage Vbias 130 may generally increase with temperature. To better approximate the required temperature correction and thereby achieve more stable operation over a wider range of temperatures, a bias voltage Vbias 130 is generated having a first temperature dependency for temperatures higher than a predetermined temperature offset, and a second, different, temperature dependency for temperatures lower than the predetermined temperature offset.

Figures 3 to 5 illustrate a bias voltage generating circuit 500 for generating the bias voltage Vbias 130 for biassing the inverter cells 200 of the ring oscillator 100. As will be described in more detail below, the bias voltage generating circuit 500 comprises a first portion, 400, 510, 520 for generating a bias current, Ibias, which is dependent on temperature and has a gain controlled by the control voltage Vtune 146 used for tuning the ring oscillator 100. The bias voltage generating circuit 500 also comprises a second portion, 530, comprising a replica of the inverter 230, for generating the bias voltage from the bias current.

Figure 3 schematically illustrates a current-subtraction circuit 300 for generating a current, i_m1, that is proportional to temperature (T), over a first temperature range, and constant with temperature over a second temperature range. The first temperature range corresponds to temperatures below the predetermined temperature offset, and the second temperature range corresponds to temperatures including and above the predetermined temperature offset. The current-subtraction circuit 300 subtracts a sink PTAT (Proportional To Absolute Temperature) current (represented by ipc_10u) from a source constant current (represented by ic_10u) and feeds the difference, i_m1, of these two currents into an NMOS current mirror 350. The output of the current mirror 350, i_m1, is the difference of the two currents (ic_10u - ipc_10u) for temperatures at which the source current is higher than sink current and is zero otherwise. The temperature dependence of currents ic_10u, ipc_10u and i_m1 are shown in the plots of Figure 3. The predetermined temperature offset may correspond to, for example, room temperature, e.g., 27°C as indicated in the plots shown in Figure 3, and may be adjusted by changing the value of the source constant current ic_10u.

Figure 4 schematically illustrates a bias current generating circuit 400, including the current-subtraction circuit 300 of Figure 3, for outputting a bias current Ibias. In this circuit 400, the piecewise, dual-slope current, i_m1, generated by the current-subtraction circuit 300 of Figure 3, is weighted and combined with weighted versions of currents ipc and ic to generate a piecewise linear dual-slope bias current Ibias at the output 410 of the bias current generating circuit 400. The temperature-dependence of the currents ic_10u, ipc_10u, i_m1 and i_m2 indicated in the upper plots of Figure 4. The temperature-dependence of the bias current Ibias is illustrated in the lower plot of Figure 4, in which the predetermined temperature offset is indicted as 27°C. At temperatures below the predetermined temperature offset, the bias current Ibias varies linearly with temperature according to a first slope 450. At temperatures above the predetermined temperature offset, the bias current Ibias varies linearly with temperature according to a second slope 452. In the circuit of Figure 4, three different current mirror ratios are adjustable, enabling independently control the current at the predetermined temperature offset (e.g., room temperature), and the current slopes 450, 452 below and above the predetermined temperature offset, using the control inputs iptat_hot, iptat_cold and ioffset. The value of the bias current Ibias at the predetermined temperature offset can be controlled using the input ioffset. The current-temperature slope 450 at temperatures below the predetermined temperature offset can be controlled using the input iptat_cold, independently from the current-temperature slope 452 at temperatures above the predetermined temperature offset, which can be controlled using the input iptat_hot. This idea can be extended to more pieces if needed to synthesize more nonlinear current profiles. In this way, temperature-dependent frequency drifts of the ring oscillator 100 can be reduced.

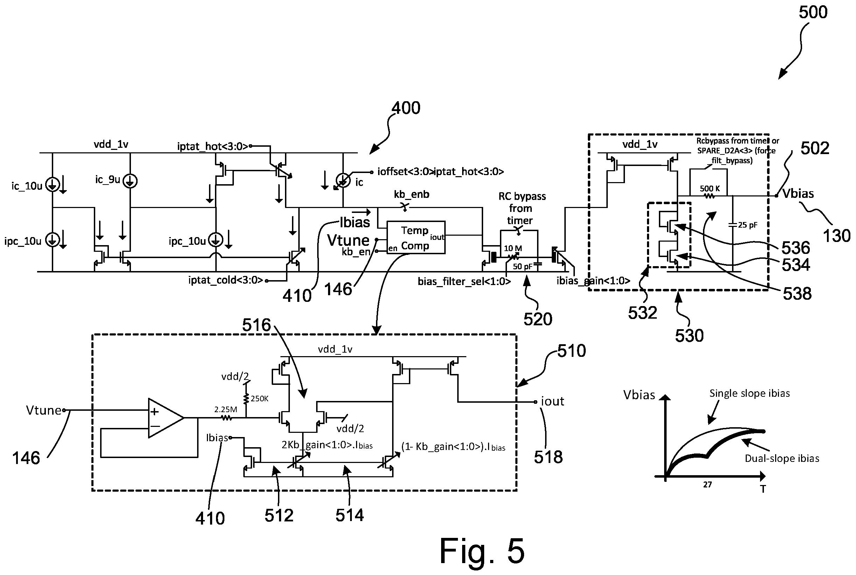

When the ring oscillator 100 is used as a VCO in a PLL, the temperature stability of the PLL can be further improved by adding a second tuning path that corrects for any drift not compensated by the PTAT biasing described above. In this mechanism, which will be described below with reference to Figure 5, the control voltage Vtune 146 coming from the loop filter of the PLL is not only fed to the varactors 246 included in the tuning capacitors 240 of the ring oscillator 100, but is also used to control the bias current Ibias 410 (generated by the circuit 400 shown in Figure 4) and thereby the bias voltage Vbias 130 for each inverter 230. This second tuning path controls the bias voltage Vbias 130 through a slow mechanism, thereby increasing the effective VCO tuning gain at low frequencies. Due to the slow nature of this second tuning path, it does not affect the noise performance or loop dynamics of the PLL.

Figure 5 schematically illustrates a bias voltage generating circuit 500 used to generate the bias voltage Vbias 130. The output 502 of the bias voltage generating circuit 500 is coupled to the bias voltage input 130 of the inverter 230 of the inverter cell 200. The bias voltage generating circuit 500 includes the circuit 400 which generates the bias current Ibias 410 as described above. The bias current Ibias 410 and the control voltage Vtune 146 are input to a temperature compensation portion 510 of the circuit 500, which provides the mechanism for the second tuning path discussed above. In the temperature compensation portion 510, the control voltage Vtune 146 is buffered, so as not to load the loop filter, and is then used to selectively control a gain of all or part of the bias current Ibias 410. The effective gain of the temperature compensation portion 510 is adjusted by Vtune, which controls how much of the bias current Ibias 410 is controlled by this loop. The bias current Ibias 410 is used to control a first current mirror 512, having a first gain (2Kb_gain) which increases with a control parameter Kb_gain, and a second current mirror 514, having a second gain (1-Kb_gain) which decreases with the control parameter Kb_gain. Thus, when Kb_gain is increased, the current carried by the first current mirror 512 increases while the current carried by the second current mirror 154 decreases. The current at the output 518 of the temperature compensation portion 510 comprises all of the current ((1-Kb_gain).Ibias) in the second current mirror 514, but only a portion of the current (2Kb_gain.Ibias) in the first current mirror 512. The portion of the current in the first current mirror 512 that goes to the output 518 is controlled by Vtune and is proportional to Vtune - vdd/2 (determined by the differential pair 516). Therefore, by changing kb_gain we change the portion of the current controlled by the Vtune and thus change the effective gain of the temperature compensation portion 510.

The output current iout 512 from the temperature compensation portion 510 is then heavily filtered by an RC filter 520, which has a dual purpose in slowing down this loop as well as filtering noise generated in the bias voltage generating circuit 500, and is then fed into a delay cell replica bias circuit portion 530 to generate the bias voltage Vbias 130 for the ring oscillator 100. This second tuning path effectively increases the VCO gain Kvco and thus the loop gain for slow variations (below the corner frequency of the RC filter 520) but does not affect it for faster variations. The temperature compensation portion 510 can be bypassed, for example on start up to charge up the capacitances.

Finally, the filtered bias current iout is input to the second portion 530 of the bias voltage generating circuit 500 to generate the bias voltage Vbias 130. The second portion 530 includes a replica delay cell 532 comprising replicas 534, 536 of the first and second NMOS transistors 250, 260 of the inverter 230. In the replica delay cell 532 a gate terminal and a drain terminal of the replica first NMOS transistor 534 are coupled to a source terminal of the replica second NMOS transistor 536. A gate terminal of the replica second NMOS transistor 536 is coupled to a drain terminal of the second NMOS transistor 534. An output 502 of the bias voltage generating circuit 500 is coupled to the drain terminal of the second NMOS transistor. A further RC filter 538 may help to reject any ripple from the supply before it reaches the bias voltage Vbias 130.

Figure 5 also shows a plot of the bias voltage Vbias against temperature, T. The thick trace illustrates the bias voltage, Vbias 130 obtained when a dual-slope, piecewise linear bias current Ibias 410 is used, as shown in the lowermost plot of Figure 4. For comparison, the thin trace shown in the plot of Figure 5 illustrates the bias voltage, Vbias 130 that would be obtained using a single-slope linear bias current instead. The dual-slope version may produce a better cancellation of temperature effects in the inverters and thus the ring oscillator. This is because the drive current of the inverter 230 does not vary linearly with temperature. Various parameters of the circuit 500 may be adjusted based on simulation results to optimise the temperature dependence of Vbias. A bias current Ibias having a temperature-dependency comprising more than two linear slopes may be used if required to further improve temperature stability. Although Figure 5 shows the bias voltage Vbias increasing with temperature, in other embodiments the bias voltage Vbias may be required to decrease with temperature. Whether Vbias increases or decreases with temperature will depend on the semiconductor process. This is because there are at least two opposing mechanisms controlling the inverter delay: as temperature increases, threshold voltages drop but mobility drops too.

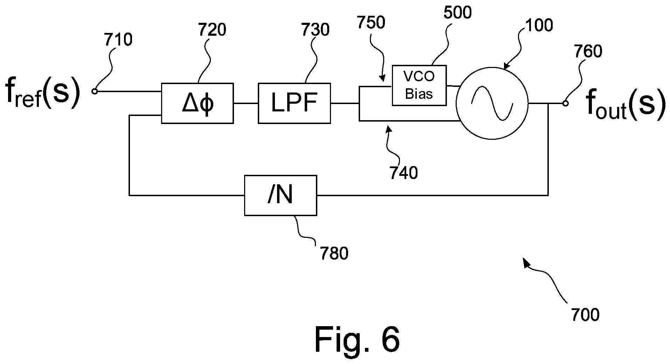

Figure 6 schematically illustrates a phase-locked loop 700 incorporating a ring oscillator 100 according to an embodiment of the present disclosure. A reference signal fref is received at an input 710 of the phase locked loop 700. The ring oscillator 100 outputs a signal fout to the output 760 of the phase-locked loop 700. A phase comparator 720 is coupled to both the input 710 and output 760 (optionally via a frequency divider 780) and is configured to output an error signal dependent on a difference between a phase of the ring oscillator output signal fout and the phase of the reference signal fref. Optionally, a low pass filter 730 is arranged to receive the error signal from the phase comparator 720 and is configured to output a control voltage Vtune for controlling the frequency and/or phase of the ring oscillator 100. The control voltage Vtune controls the frequency/phase of the ring oscillator 100 via two pathways 740, 750. In a first pathway 740, the control voltage Vtune is connected to the third control input 146 of each inverter 200 for controlling the effective value of the variable capacitance Cvar 246 which is parallel-coupled to the respective inverter output 220. In a second pathway 750, the control voltage Vtune is input to the circuitry 500 for generating the bias voltage Vbias applied to the bias voltage input 130 of each inverter 100.

Although particular example embodiments of the disclosure have been described above, it will be appreciated than many modifications, including additions and/or substitutions, may be made within the scope of the appended claims.

## Claims

1. A ring oscillator, comprising:
a plurality of inverters arranged in a ring,
wherein each inverter comprises an inverter input and an inverter output, and wherein the inverter output of each inverter in the ring is coupled to the inverter input of the respective next inverter in the ring; and
wherein at least one inverter of said plurality of inverters further comprises:
a first NMOS transistor, comprising a first gate terminal coupled to said respective inverter input, a first drain terminal coupled to said respective inverter output, and a first source terminal; and
a second NMOS transistor, comprising a second gate terminal, a second drain terminal and a second source terminal, wherein said second source terminal is coupled to said first drain terminal.

2. A ring oscillator according to claim 1, wherein said at least one inverter further comprises:
a bias voltage input coupled to said second gate terminal; and
a resistance coupled between said bias voltage input and said second gate terminal.

3. A ring oscillator according to claim 2, wherein said resistance is a variable resistance.

4. A ring oscillator according to any one of the preceding claims, wherein said at least one inverter further comprises: at least one capacitance coupled between said inverter output and a reference voltage.

5. A ring oscillator according to any one of the preceding claims, wherein said at least one inverter further comprises: at least one variable capacitance coupled between said inverter output and a control voltage.

6. A ring oscillator according to any one of the preceding claims, wherein:
said second drain terminal is coupled to a supply voltage; and/or
said first source terminal is coupled to a reference voltage.

7. A ring oscillator according to any one of the preceding claims, further comprising:
circuitry comprising an output coupled to the bias voltage input of said at least one inverter;
said circuitry being configured to generate, at its output, a bias voltage varying with temperature.

8. A ring oscillator according to claim 7, wherein said bias voltage has a first temperature dependency for temperatures above a predetermined temperature offset, and a second, different, temperature dependency for temperatures below the predetermined temperature offset.

9. A ring oscillator according to claim 7 or claim 8, wherein said circuitry is configured to generate said bias voltage based on a temperature-dependent current.

10. A ring oscillator according to claim 9, wherein said circuitry comprises:
a first portion configured to generate a bias current based on said temperature-dependent current, wherein said bias current varies linearly with temperature with a first slope at temperatures below the predetermined temperature offset, and wherein said bias current varies linearly with temperature with a second slope at temperatures above the predetermined temperature offset; and
a second portion configured to generate said bias voltage based on said bias current.

11. A ring oscillator according to claim 10, wherein said first portion of the circuitry comprises a current-subtraction circuit configured to subtract said temperature-dependent current from a constant current.

12. A ring oscillator according to claim 10 or 11, wherein: said circuitry is configured to receive a control voltage and to control a gain of said bias current dependent on said control voltage.

13. A ring oscillator according to any one of claims 10 to 12, wherein said second portion comprises a delay cell including a replica of the first and second NMOS transistors.

14. A ring oscillator according to any one of claims 10 to 13, wherein said circuitry comprises at least one RC filter for filtering said bias current.

15. A phase locked loop, comprising:
a ring oscillator according to any one of the preceding claims; and
a phase comparator for outputting a control signal dependent on a difference between a phase of a signal at an output of the ring oscillator and a phase of a reference signal, for controlling a frequency and/or phase of the ring oscillator.

## Amended claims

### Amended claims in accordance with Rule 137(2) EPC.

1. A ring oscillator (100), comprising:
a plurality of inverters (200) arranged in a ring,
wherein each inverter (200) comprises an inverter input (210) and an inverter output (220), and wherein the inverter output (220) of each inverter (200) in the ring is coupled to the inverter input (210) of the respective next inverter (200) in the ring; and
wherein at least one inverter (200) of said plurality of inverters further comprises:
a first NMOS transistor (250), comprising a first gate terminal (252) coupled to said respective inverter input (210), a first drain terminal (254) coupled to said respective inverter output (220), and a first source terminal (256);
a second NMOS transistor (260), comprising a second gate terminal (262), a second drain terminal (264) and a second source terminal (266), wherein said second source terminal (266) is coupled to said first drain terminal (254);
a bias voltage input (130) coupled to said second gate terminal (262); and
a resistance (270) coupled between said bias voltage input (130) and said second gate terminal (262).

2. A ring oscillator (100) according to claim 1, wherein said resistance (270) is a variable resistance.

3. A ring oscillator (100) according to any one of the preceding claims, wherein said at least one inverter (200) further comprises:
at least one capacitance (240) coupled between said inverter output (220) and a reference voltage.

4. A ring oscillator (100) according to any one of the preceding claims, wherein said at least one inverter (200) further comprises:
at least one variable capacitance (248) coupled between said inverter output and a control voltage (146).

5. A ring oscillator (100) according to any one of the preceding claims, wherein:
said second drain terminal (264) is coupled to a supply voltage (110); and/or
said first source terminal (256) is coupled to a reference voltage.

6. A ring oscillator (100) according to any one of the preceding claims, further comprising:
circuitry (500) comprising an output (502) coupled to the bias voltage input (130) of said at least one inverter (200);
said circuitry (500) being configured to generate, at its output (502), a bias voltage varying with temperature.

7. A ring oscillator (100) according to claim 6, wherein said bias voltage has a first temperature dependency for temperatures above a predetermined temperature offset, and a second, different, temperature dependency for temperatures below the predetermined temperature offset.

8. A ring oscillator (100) according to claim 6 or claim 7, wherein said circuitry (500) is configured to generate said bias voltage based on a temperature-dependent current.

9. A ring oscillator (100) according to claim 9, wherein said circuitry (500) comprises:
a first portion (400, 510, 520) configured to generate a bias current (Ibias) based on said temperature-dependent current, wherein said bias current varies linearly with temperature with a first slope at temperatures below the predetermined temperature offset, and wherein said bias current (Ibias) varies linearly with temperature with a second slope at temperatures above the predetermined temperature offset; and
a second portion (530) configured to generate said bias voltage based on said bias current.

10. A ring oscillator (100) according to claim 9, wherein said first portion of the circuitry (400, 510, 520) comprises a current-subtraction circuit (300) configured to subtract said temperature-dependent current from a constant current.

11. A ring oscillator (100) according to claim 9 or 10, wherein:
said circuitry (500) is configured to receive a control voltage (Vtune) and to control a gain of said bias current (Ibias) dependent on said control voltage (Vtune).

12. A ring oscillator (100) according to any one of claims 9 to 11, wherein said second portion (530) comprises a delay cell (532) including a replica of the first and second NMOS transistors (250, 260).

13. A ring oscillator (100) according to any one of claims 9 to 12, wherein said circuitry (500) comprises at least one RC filter (520) for filtering said bias current (Ibias).

14. A phase locked loop (700), comprising:
a ring oscillator (100) according to any one of the preceding claims; and
a phase comparator (720) for outputting a control signal dependent on a difference between a phase of a signal (fout) at an output of the ring oscillator (100) and a phase of a reference signal (fref), for controlling a frequency and/or phase of the ring oscillator (100).
